# EUROPÄISCHE PATENTSCHRIFT

(11) **EP 0 735 559 B1**
(45) Veröffentlichungstag und Bekanntmachung des Hinweises auf die Patenterteilung: **16.02.2000**
(21) Anmeldenummer: 95120007.0
(22) Anmeldetag: 18.12.1995
(51) Int. Cl.: H01H 50/14, H01H 50/04, H01H 50/08

(54) **Sockelteil mit einem elektromagnetischen Schaltgerät, insbesondere einem Schütz**
Base with an electromagnetic switch device, particularly a protective switch
Socle avec un appareil de commutation électromagnétique, en particulier un disjoncteur de protection

(30) Priorität: 25.03.1995 CH 85095
(43) Veröffentlichungstag der Anmeldung: 02.10.1996
(73) Patentinhaber: Rockwell Automation AG, CH-5001 Aarau (CH)
(72) Erfinder: Koller, Erich, CH-5504 Othmarsingen (CH); Weichert, Hans, CH-5722 Gränichen (CH); Zumkeller, Daniel, DH-4333 Münchwilen (CH)
(74) Vertreter: Morva, Tibor

(56) Entgegenhaltungen:
- EP-A- 0 423 899
- DE-A- 2 409 660
- DE-A- 3 045 006
- DE-A- 4 406 682

## Beschreibung

Die vorliegende Erfindung betrifft einen Sockelteil mit einem elektromagnetischen Schaltgerät, insbesondere einem Schütz, mit einer Grundplatte, mit einem im Sockelteil untergebrachten Kern des Elektromagneten, mit einer zur Erregung des Elektromagneten dienenden Magnetspule und mit einer für die Herstellung von elektrischen Verbindungen sowohl im Sockelteil des Schaltgerätes als auch zwischen dem Sockelteil und den von aussen zugänglichen, am Sockelteil befestigten Anschlusstücken des Schaltgerätes vorgesehenen, mindestens an einer Seite mit mehreren Leiterbahnen versehenen, zur Hauptsache aus elektrischem Isoliermaterial bestehenden Leiterbahnplatte.

Aus der DE-A1-3045006 ist ein elektromagnetisches Schaltgerät mit einem an einer Grundplatte befestigten Elektromagneten und mit einer Magnetspule bekannt. Dieses Schaltgerät ist steckbar. An einer gestreckten Leiterbahnfolie werden bei der Herstellung des Schaltgerätes die einzelnen Steckkontaktstücke, die Schaltkontaktstücke des Schaltgerätes und die Anschlüsse der Magnetspule angelötet. Danach wird die Leiterbahnfolie geknickt, wobei das mit der Grundplatte in einem Gehäuse untergebrachte Schaltgerät an der Innenseite des Gehäuses durch die Leiterbahnfolie verdrahtet und an der dem Gehäuse abgekehrten Seite mit den an der Leiterbahnfolie angelöteten, vorstehenden Steckkontaktstiften versehen ist. Der Nachteil dieses Schaltgerätes besteht einerseits darin, dass die Montage des Schaltgerätes wegen des angewendeteten Lötverfahrens verhältnismässig teuer ist und anderseits darin, dass eine allfällige Reparatur des Schaltgerätes mit aufwendigen Lötarbeiten verbunden ist.

Aus der DE-A1-4406682 ist ein weiteres elektromagnetisches Schaltgerät bekannt. Dieses Schaltgerät is unter anderem mit einem Elektromagneten und mit einer Magnetspule ausgerüstet. Die Anschlusstücke der Magnetspule sind an einem Flansch des Spulenkörpers befestigt. Diese Anschlusstücke stehen mit den von aussen zugänglichen Spulenanschlusstellen des Schaltgerätes über Verbindungsschienen in Steckverbindung. Obwohl die Anschlusstücke der Magnetspule auf die Verbindungsschienen steckbar ausgebildet sind, ist der Anschluss von Zusatzelementen, wie beispielsweise Ueberspannungsschutz, an den Spulenklemmen verhältnismässig schwierig. Im weiteren ist die Montage dieses Schaltgerätes wegen den komplizierten Verbindungsschienen zwischen den steckbaren Anschlusstücken der Magnetspule und den von aussen zugänglichen Spulenanschlusstellen mit verhältnismässig hohem Aufwand verbunden.

Aufgabe der vorliegenden Erfindung ist es, einen Sockelteil mit einem elektromagnetischen Schaltgerät vorzuschlagen, der eine einfache Montage sowohl der Magnetspule als auch der Zusatzelemente ermöglicht, bei welchem eine allfällige Reparatur des Schaltgerätes einfach durchführbar ist und der wirtschaftliche Vorteile aufweist.

Die gestellte Aufgabe ist dadurch gelöst, dass die Leiterbahnen an der dem Kern zugekehrten Seite der an der Grundplatte befestigten Leiterbahnplatte mehrere, senkrecht zur Leiterbahnplatte federnde Stumpfkontaktstücke und/oder senkrecht zur Leiterbahnplatte steckbare Steckkontaktstücke aufweisen, an denen mindestens die an einem Flansch des Spulenkörpers der Magnetspule befestigten Anschlusskontaktstücke der Magnetspule angeschlossen sind. Die Montage dieses Sockelteiles ist einfach, weil die Magnetspule und alle vorgesehenen Zusatzelemente entweder an federnden Stumpfkontaktstücken ansetzbar oder steckbar sind. Bei einer allfälligen Reparatur können die schadhaften Teile durch Herausziehen oder Ausstecken einfach gewechselt werden. Die einfache Ausbildung dieses Sockelteiles sichert auch wirtschaftliche Vorteile.

Die Leiterbahnplatte kann an der Grundplatte mittels Kunststoffzapfen befestigt sein. Die an der Grundplatte angeformten Kunststoffzapfen ermöglichen eine einfache Montage der Leiterbahnplatte an der Grundplatte.

Die am Spulenkörper befestigten Anschlusskontaktstücke der Magnetspule sind vorteilhafterweise mit den Kontaktstücken der Leiterbahnen durch die Halterung des Spulenkörpers in der Eingriffstellung gehalten. Eine einfache Halterung ist beispielsweise durch die auf den Sockelteil aufgesetzten weiteren Gehäuseteile möglich. Mit Vorteil ist dabei der Spulenkörper in der Grundplatte des Sockelteils durch Reibschluss zusätzlich gehalten, um nach Aufhebung der Halterung des Spulenkörpers den Spulenkörper in der Grundplatte zurückzuhalten. Diese zusätzliche Halterung erlaubt die Entfernung der betriebsmässigen Halterung des Spulenkörpers, ohne dass der Spulenkörper in Vertikallage des Sockelteils daraus herausfällt.

Die an der Leiterbahnplatte vorhandenen Steckkontaktstücke können Kontaktbuchsen sein, die für die Aufnahme von Kontaktstiften mindestens einer mit einer elektronischen Schaltanordnung versehenen Schaltungsplatte ausgebildet sind. Diese Lösung ermöglicht das einfache Einsetzen einer mit einer elektronischen Schaltanordnung ausgerüsteten Schaltungsplatte als Zusatzelement.

Die Leiterbahnen weisen von aussen zugängliche Anschlusstücke auf, die mit Vorteil in einem kippbaren Anschlusskasten über flexible Verbindungen untergebracht sind. Durch die Verwendung eines während der Montage wegkippbaren Anschlusskastens können die Abmessungen des Schaltgerätes verhältnismässig klein gehalten werden, weil bei der Montage trotz betriebsmässig gedrängter Anordnung die Anschlüsse gut zugänglich sind. Der kippbare Anschlusskasten kann vorteilhafterweise einen Schlitz aufweisen, durch welchen eine die Identifikationsangaben der mit einer elektronischen Schaltanordnung versehenen Schaltungsplatte tragende und an dieser Schaltungsplatte befestigte Zunge von aussen lesbar herausragt. Bei dieser Anordnung können die Identifikationsangaben des im Schaltgerät untergebrachten Zusatzelementes, beispielsweise einer elektronischen Schaltanordnung, von aussen erkannt werden, ohne dass man das Gehäuse des Schaltgerätes öffnen muss.

Ein an einer Leiterbahn angeschlossenes, federndes Stumpfkontaktstück kann am betriebsmässig in den Sockelteil eingesetzten Kern elektrisch leitend anstehen. Diese Kontaktstelle ermöglicht zwischen dem Kern des Elektromagneten und einer mit den Leiterbahnen der Leiterbahnplatte in elektrisch leitender Verbindung stehenden elektronischen Schaltanordnung eine Entstörungsverbindung herzustellen. Die Entstörungsverbindung dient zur Herabsetzung des beobachteten Störeinflusses des Schaltgerätes auf die externe Steuerstromkreise.

Im folgenden wird anhand der beiliegenden Zeichnungen ein Ausführungsbeispiel der Erfindung näher beschrieben. Es zeigen:
- Fig.1: eine perspektivische, teilweise fluchtbildartige Darstellung des Sockelteils eines elektromagnetischen Schaltgerätes und
- Fig.2: eine perspektivische Darstellung der im Sockelteil befestigten Leiterbahnplatte in etwas grösserem Masstab.

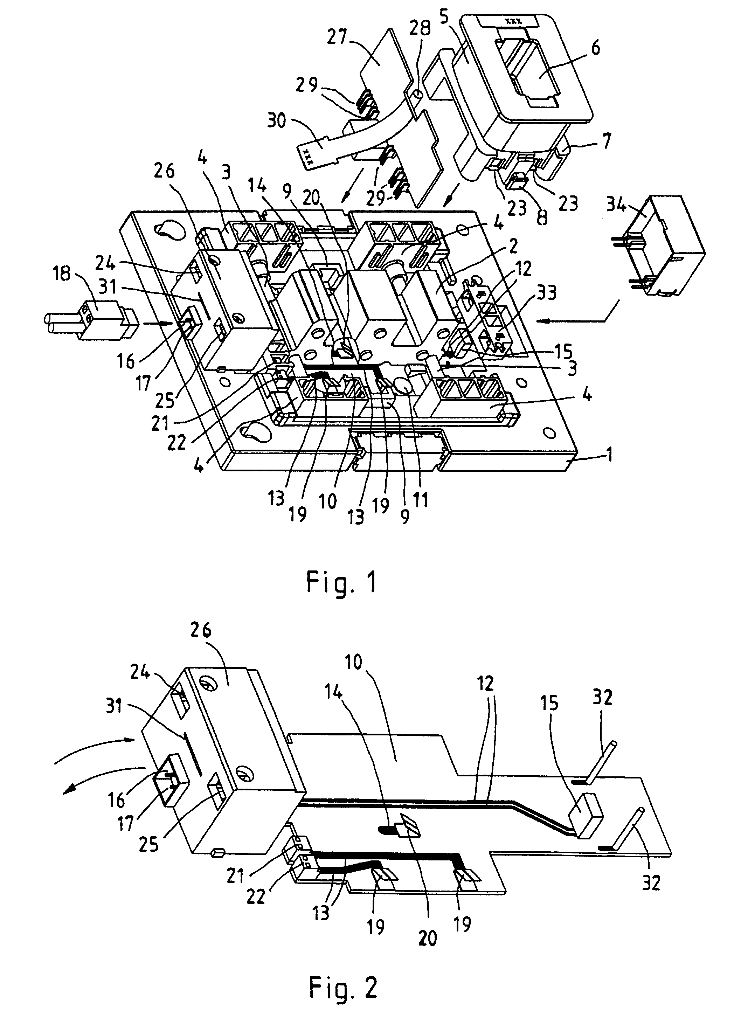

In Fig.1 ist eine perspektivische und teilweise fluchtbildartige Darstellung eines Sockelteils eines elektromagnetischen Schaltgerätes ersichtlich. Der Sockelteil ist auf einer Grundplatte 1 aufgebaut. Der E-Kern 2 des Elektromagneten des elektromagnetischen Schaltgerätes, in diesem Ausführungsbeispiel eines Schützes, ist mit zwei Bolzen 3 an angeformten Aufbauteilen 4 der Grundplatte 1 befestigt. Auf den mittleren Schenkel des E-Kernes 2 wird bei der Montage die im Fluchtbild dargestellte, zur Erregung des Elektromagneten dienende Magnetspule 5 mit dem Spulenkörper 6 aufgeschoben. Der Spulenkörper 6 weist am unteren Flansch 7 beidseitig je einen Vorsprung 8 auf, die je einen Gummiring tragen. Diese Vorsprünge 8 passen in die an der Grundplatte 1 angeformten Kanäle 9 hinein. Zwischen den mit Gummiringen versehenen Vorsprüngen 8 und den Kanälen 9 entsteht nach der Montage der Magnetspule 5 ein Reibschluss. Diese Reibschlussverbindung hält die Magnetspule 5 auch in der vertikalen Lage an der Grundplatte 1 zurück, wenn die nicht dargestellte, betriebsmässige Halterung der Magnetspule 5 entfernt wird. Die nicht dargestellte, betriebsmässige Halterung der Magnetspule 5 erfolgt durch Anliegen des nicht dargestellten Oberteils des Gehäuses des Schaltgerätes am Spulenkörper 6. Die Reibschlussverbindung zwischen dem Spulenkörper 6 und der Grundplatte 1 verhindert bei einem Wechsel der Magnetspule 5 oder eines anderen Teiles des Schaltgerätes, dass die Magnetspule 5 nach Entfernen des Oberteils des Gehäuses aus der Grundplatte 1 herausfällt.

Zwischen dem Kern 2 und der Grundplatte 1 ist eine auch in Fig.2 in etwas grösserem Masstab gezeigte Leiterbahnplatte 10 an der Grundplatte 1 mit an der Grundplatte 1 angeformten Kunststoffzapfen 11 befestigt. Die Leiterbahnplatte 10 ist an ihren beiden Seiten mit mehreren Leiterbahnen 12, 13, 14 versehen. Die Herstellung von Leiterbahnplatten ist allgemein bekannt, so dass deren Herstellung hier nicht näher behandelt werden muss. Die Leiterbahnen 12, 13, 14 liegen an den Oberflächen der zur Hauptsache aus elektrischem Isoliermaterial bestehenden Leiterbahnplatte 10. Die beiden Leiterbahnen 12 stehen mit einer an der Leiterbahnplatte 10 befestigten Schnittstelleneinheit 15 in Verbindung. Die Schnittstelleneinheit 15 ermöglicht die Ansteuerung des Schaltgerätes über elektronische, auf die Leiterbahnplatte 10 steckbare Schaltanordnungen. Die Verbindung zwischen den für diese steckbaren Schaltanordnungen auf der Leiterbahnplatte 10 vorgesehenen Kontaktbuchsen und der Schnittstelleneinheit 15 erfolgt über mehrere in den Figuren an der nicht sichtbaren Seite der Leiterbahnplatte 10 vorhandene Leiterbahnen. Die der Schnittstelleneinheit 15 abgekehrten Enden der beiden Leiterbahnen 12 sind über flexible elektrische Verbindungen mit den von aussen zugänglichen Steckkontaktstücken 16, 17 elektrisch leitend verbunden. Ueber den Stecker 18 ist die Schnittstellen einheit 15 von aussen anschliessbar. Andere Schnittstelleneinheiten, wie beispielsweise optische, sind mit entsprechend ausgebildeten Anschlusstellen und Verbindungen auch verwendbar.

Die Leiterbahnen 13 und 14 weisen an ihren dem E-Kern 2 zugekehrten Seiten senkrecht zur Leiterbahnplatte 10 federnde Stumpfkontaktstücke 19, 20 und senkrecht zur Leiterbahnplatte 10 steckbare Steckkontaktstücke auf 21, 22 auf. Das federnde Stumpfkontaktstück 20 steht beim montierten E-Kern 2 an der der Grundplatte 1 zugekehrten Seite des E-Kernes 2 am E-Kern 2 elektrisch leitend an. Die am Stumpfkontaktstück 20 angeschlossenen Leiterbahn 14 verbindet den betriebsmässig montierten E-Kern 2 mit einer an den Steckkontaktstücken angeschlossenen, elektronischen Schaltanordnung entweder direkt oder über Kondensatoren und bildet eine mindestens bei höheren Frequenzen wirksame Entstörungsverbindung zwischen diesen Teilen. Diese Entstörungsverbindung hilft den beobachteten Störeinfluss des Schaltgerätes auf die externen Steuerstromkreise herabzusetzen.

Am Flansch 7 des Spulenkörpers 6 sind die Anschlusskontaktstücke 23 der Magnetspule 5 befestigt. Bei montiertem Spulenkörper 6 stehen diese Anschlusskontaktstücke 23 mit den federnden Stumpfkontaktstücken 19 in elektrischer Verbindung. Die Magnetspule 5 wird über die Leiterbahnen 13 mit Strom versorgt. Die von aussen zugänglichen Anschlusstücke 24, 25 der Magnetspule 5 sind über flexible Leiter im kippbaren Anschlusskasten 26 befestigt. Der Anschlusskasten 26 wird bei der Montage des Sockelteils des Schaltgerätes von der Grundplatte 1 weggeschwenkt und die Anschlüsse für die Magnetspule 5 und für die Schnittstelleneinheit 15 von hinten angelötet. Dieser kippbare Anschlusskasten 26 erlaubt die Abmessungen des Schaltgerätes zu verringern, weil bei der Montage für die Zugänglichkeit der Lötanschlüsse im abgeklappten Anschlusskasten 26 keine die Abmessungen des Schaltgerätes vergrössernden Räume erforderlich sind.

Die Schaltungsplatte 27 enthält eine elektronische Schaltanordnung zur Steuerung des zur Magnetspule 5 geführten Erregerstromes. Der Erregerstrom wird vom Luftspalt des Elektromagneten abhängig gesteuert. Zu diesem Zweck trägt die Schaltungsplatte 27 einen magnetischen Sensor 28, der den Erregerstrom beeinflusst. Eine solche Schaltungsanordnung ist im Schweizer Patentgesuch der Anmelderin, Nr. 00374/95-6 vom 09.02.1995 beschrieben. Die Schaltungsplatte 27 trägt Stiftkontakte 29, die in die mit den Leiterbahnen der Leiterbahnplatte 10 verbundene Steckkontaktstücke oder Kontaktbuchsen 21, 22 einsteckbar sind. In den Figuren sind nicht alle Kontaktbuchsen sichtbar, weil sie durch den Anschlusskasten 26 verdeckt sind. Die Stromversorgung der Magnetspule 5 führt von den Anschlusstücken 24, 25 zu den Leiterbahnen der Leiterbahnplatte 10, dann über die Schaltanordnung auf der eingesteckten Schaltungsplatte 27 zu den Leiterbahnen 13 und zum Schluss über die federnden Stumpfkontaktstücke 19 zu den Anschlusskontaktstücken 23 der auf die Grundplatte und auf den mittleren Schenkel des E-Kernes 2 aufgesteckten Magnetspule 5.

An der Schaltungsplatte 27 ist eine flexible Zunge 30 befestigt. An der Spitze dieser Zunge 30 sind die Identifikationsangaben der auf der Schaltungsplatte 27 aufgebrachten elektronischen Schaltanordnung angegeben. Bei in die Kontaktbuchsen eingesteckter Schaltungsplatte 27 wird die Spitze der Zunge 30 durch den im Anschlusskasten 26 vorhandenen Schlitz 31 gestossen. Beim fertig montierten Schaltgerät ragt die Spitze der Zunge 30 aus dem Schlitz 31 heraus, so dass die Identifikationsangaben der eingesetzten elektronischen Schaltanordnung von aussen, ohne Oeffnen des Gehäuses, erkennbar sind.

Die Leiterbahnen sind unter der Leiterbahnplatte 10 bis zu den beiden aus der Leiterbahnplatte 10 vorstehenden, in Fig.2 erkennbaren Anschlusstiften 32 weitergeführt. An diesen Anschlusstiften 32 ist über das in Fig.1 sichtbare Anschlusstück 33 eine Ueberspannungsschutzeinrichtung 34, die bevorzugt aus einem spannungsabhängigen Widerstand besteht, angeschlossen. Diese Ueberspannungsschutzeinrichtung 34 steht somit mit den Anschlusstücken 24 und 25 der Magnetspule 5 in elektrisch leitender Verbindung.

## Patentansprüche

1. Sockelteil mit einem elektromagnetischen Schaltgerät, insbesondere einem Schütz, mit einer Grundplatte, mit einem im Sockelteil untergebrachten Kern des Elektromagneten, mit einer zur Erregung des Elektromagneten dienenden Magnetspule und mit einer für die Herstellung von elektrischen Verbindungen sowohl im Sockelteil des Schaltgerätes als auch zwischen dem Sockelteil und den von aussen zugänglichen, am Sockelteil befestigten Anschlusstücken des Schaltgerätes vorgesehenen, mindestens an einer Seite mit mehreren Leiterbahnen versehenen, zur Hauptsache aus elektrischem Isoliermaterial bestehenden Leiterbahnplatte, **dadurch gekennzeichnet, dass** die Leiterbahnen (12, 13, 14) an der dem Kern (2) zugekehrten Seite der an der Grundplatte (1) befestigten Leiterbahnplatte (10) mehrere, senkrecht zur Leiterbahnplatte (10) federnde Stumpfkontaktstücke (19, 20) und/oder senkrecht zur Leiterbahnplatte (10) steckbare Steckkontaktstücke (21, 22) aufweisen, an denen mindestens die an einem Flansch (7) des Spulenkörpers (6) der Magnetspule (5) befestigten Anschlusskontaktstücke (23) der Magnetspule (5) angeschlossen sind.

2. Vorrichtung nach Anspruch 1, **dadurch gekennzeichnet, dass** die Leiterbahnplatte (10) an der Grundplatte (1) mittels Kunststoffzapfen (11) befestigt ist.

3. Vorrichtung nach Anspruch 1, **dadurch gekennzeichnet, dass** die am Spulenkörper (6) befestigten Anschlusskontaktstücke (23) der Magnetspule (5) mit den Stumpfkontaktstücken (19) der Leiterbahnen (13) durch die Halterung des Spulenkörpers (6) in der Eingriffstellung gehalten sind.

4. Vorrichtung nach Anspruch 3, **dadurch gekennzeichnet, dass** der Spulenkörper (6) in der Grundplatte (1) des Sockelteils durch Reibschluss zusätzlich gehalten ist, um nach Aufhebung der Halterung des Spulenkörpers (6) den Spulenkörper (6) in der Grundplatte (1) zurückzuhalten.

5. Vorrichtung nach Anspruch 1, **dadurch gekennzeichnet, dass** die an der Leiterbahnplatte (10) vorhandenen Steckkontaktstücke (21, 22) Kontaktbuchsen sind, die für die Aufnahme von Kontaktstiften (29) mindestens einer mit einer elektronischen Schaltanordnung versehenen Schaltungsplatte (27) ausgebildet sind.

6. Vorrichtung nach Anspruch 1, **dadurch gekennzeichnet, dass** die Leiterbahnen (12, 13) von aussen zugängliche Anschlusstücke (16, 17, 24, 25) aufweisen, die in einem kippbaren Anschlusskasten (26) über flexible Verbindungen untergebracht sind.

7. Vorrichtung nach den Ansprüchen 5 und 6, **dadurch gekennzeichnet, dass** der kippbare Anschlusskasten (26) einen Schlitz (31) aufweist, durch welchen eine die Identifikationsangaben der mit einer elektronischen Schaltanordnung versehenen Schaltungsplatte (27) tragende und an dieser Schaltungsplatte (27) befestigte Zunge (30) von aussen lesbar herausragt.

8. Vorrichtung nach Anspruch 1, **dadurch gekennzeichnet, dass** ein an einer Leiterbahn (14) angeschlossenes, federndes Stumpfkontaktstück (20) am - betriebsmässig in den Sockelteil eingesetzten Kern (2) elektrisch leitend ansteht.

## Claims

1. A base member with an electromagnetic switch device particular a contactor, a mounting plate, a core of the electromagnet accommodated in the base member, a magnet coil which serves to excite the electromagnet, and a conductor path board which is provided for establishing electric connections both in the base member of the switch device and also between the base member and the externally accessible connectors of the switch device attached to the base member, is equipped at least on one side with a plurality of conductor paths, and consists mainly of electric insulating material, characterised in that on the side, facing towards the core (2), of the conductor path board (10) attached to the mounting plate (1), the conductor paths (12, 13, 14) comprise a plurality of butt contact pieces (19, 20) sprung at right angles to the conductor path board (10) and/or of plug contact pieces (21, 22) insertable at right angles to the conductor path board (10), to which are connected at least the connecting contact pieces (23) of the magnet coil (5) which are attached to a flange (7) of the coil body (6) of the magnet coil (5).

2. A device according to Claim 1, characterised in that the conductor path board (10) is attached to the mounting plate (1) by means of synthetic resin pins (11).

3. A device according to Claim 1, characterised in that the connecting contact pieces (23) of the magnet coil (5), which are attached to the coil body (6), are held in engagement with the butt contact pieces (19) of the conductor paths (13) by the retention means of the coil body (6).

4. A device according to Claim 3, characterised in that the coil body (6) additionally is retained by friction in the mounting plate (1) of the base member in order to maintain the coil body (6) in the mounting plate (1) following the withdrawal of the retention means of the coil body (6).

5. A device according to Claim 1, characterised in that the plug contact pieces (21, 22) provided on the conductor path board (10) are contact bushes which are designed to receive contact pins (29) of at least one circuit board (27) provided with an electronic switching arrangement.

6. A device according to Claim 1, characterised in that the conductor paths (12, 13) have externally accessible terminals (16, 17, 24, 25) which are accommodated in a tiltable terminal box (26) via flexible connections.

7. A device according to Claims 5 and 6, characterised in that the tiltable terminal box (26) has a slot (31) through which a tongue (30), which bears the identification data of the circuit board (27) provided with an electronic switching arrangement and is attached to said circuit board (27), projects so as to be legible from the exterior.

8. A device according to Claim 1, characterised in that a sprung butt contact piece (20), connected to a conductor path (14), is electrically conductively connected to the core (2) operationally inserted into the base member.

## Revendications

1. Pièce de socle avec un appareil électromagnétique de coupure, en particulier un contacteur, comprenant une plaque de base, un noyau de l'électro-aimant logé dans la pièce de socle, une bobine d'électro-aimant servant à l'excitation de l'électro-aimant, une carte de circuits imprimés réalisée pour l'essentiel en une matière électriquement isolante, pourvue sur au moins un côté de plusieurs pistes conductrices, prévue pour établir des liaisons électriques aussi bien dans la pièce de socle de l'appareil de coupure qu'entre la pièce de socle et les pièces de raccordement fixées sur la pièce de socle, et accessibles de l'extérieur,
caractérisée en ce que
les pistes conductrices (12, 13, 14) présentent sur le côté tourné vers le noyau (2) de la carte de circuits imprimés (10), fixée sur la plaque de base (1), plusieurs pièces de contact camuses (19, 20) qui font ressort perpendiculairement à la carte de circuits imprimés (10), et/ou des pièces de contact par enfichage (21, 22) que l'on peut enficher perpendiculairement à la carte de circuits imprimés (10), auxquelles sont raccordées au moins les pièces de contact de raccordement (23) de la bobine de l'électro-aimant (5), qui sont fixées sur une bride (7) du corps (6) de la bobine de l'électro-aimant (5).

2. Dispositif selon la revendication 1,
caractérisé en ce que
la carte de circuits imprimés (10) est fixée sur la plaque de base (1) au moyen de tenons en matière plastique (11).

3. Dispositif selon la revendication 1,
caractérisé en ce que
les pièces de contact de raccordement (23) de la bobine de l'électro-aimant (5), fixées sur le corps de la bobine (6), sont maintenues dans leur position de venue en prise avec les pièces de contact camuses (19) des pistes conductrices (13) par la fixation du corps de la bobine (6).

4. Dispositif selon la revendication 3,
caractérisé en ce que
le corps de la bobine (6) est maintenu en plus par un engagement à friction dans la plaque de base (1) de la pièce de socle, pour retenir après le soulèvement de la fixation du corps de la bobine (6) le corps de la bobine (6) dans la plaque de base (1).

5. Dispositif selon la revendication 1,
caractérisé en ce que
les pièces de contact par enfichage (21, 22) qui existent sur la carte de circuits imprimés (10) sont des douilles de contact qui sont constituées pour recevoir des broches de contact (29) d'au moins une plaquette à circuits imprimés (27) pourvue d'un circuit électronique.

6. Dispositif selon la revendication 1,
caractérisé en ce que
les pistes conductrices (12, 13) présentent des pièces de raccordement (26) qui sont accessibles de l'extérieur, et qui sont logées dans une boîte de raccordement qui peut basculer (26) par l'intermédiaire de liaisons flexibles.

7. Dispositif selon les revendications 5 et 6,
caractérisé en ce que
la boîte de raccordement (26) qui peut basculer, présente une fente (31), à travers laquelle pénètre de l'extérieur de façon lisible une languette (30) qui porte les indications d'identification de la plaquette à circuits imprimés (27) pourvue d'un circuit électronique et qui est fixée sur cette plaquette à circuits imprimés (27).

8. Dispositif selon la revendication 1,
caractérisé en ce que
une pièce de contact camuse (20) qui fait ressort et qui est raccordée à une piste conductrice (14), est mise en contact électrique de façon à fonctionner avec le noyau (2) inséré dans la pièce de socle.
